# EUROPEAN PATENT APPLICATION

(11) **EP 4 576 957 A1**
(43) Date of publication of application: **25.06.2025**
(21) Application number: 23877518.3
(22) Date of filing: 14.09.2023
(51) Int. Cl.: H05K 7/14, H05K 9/00, H01M 50/284

(54) **BMS GROUND ASSEMBLY**

(30) Priority: 11.10.2022 KR 20220130047
(71) Applicant: LG Energy Solution, Ltd., Seoul 07335 (KR)
(72) Inventor: YOON, Sang Hyun, Daejeon 34122 (KR)
(74) Representative: Plasseraud IP
(86) International application number: PCT/KR2023/013844
(87) International publication number: WO 2024/080589

(57) **Abstract**

The present invention relates to a battery management system (BMS) including: a circuit board in which a first coupling hole for grounding is defined; a first casing mold that accommodates the circuit board, and includes a bushing part disposed inside a second coupling hole recessed from the outside; and a coupling unit that passes through the first coupling hole and the second coupling hole, and allows the circuit board and the bushing part to be in contact with each other while pressing a top surface of the bushing part, wherein the bushing part includes: a vertical part provided in a direction parallel to the second coupling hole; and a horizontal part extending from an end of the vertical part in a direction perpendicular to a direction in which the vertical part is provided, wherein the coupling unit is electrically connected to a case, in which a plurality of batteries are accommodated, to ground the circuit board.

## Description

### TECHNICAL FIELD

### CROSS-REFERENCE TO RELATED APPLICATION

The present application claims the benefit of the priority of Korean Patent Application No. 10-2022-0130047, filed on October 11, 2022, which is hereby incorporated by reference in its entirety.

### TECHNICAL FIELD

The present invention relates to a circuit board grounding assembly, and more particularly, to a BMS grounding assembly including a structure for grounding a BMS circuit board.

### BACKGROUND ART

Printed circuit bounds (PCB) are necessary parts used for almost every electronic equipment, and are printed circuit boards that are wired and provided on insulation plates so as to circuitally connect electric/electronic devices. The PCBs each have a structure in which a conductor and an insulator are stacked in the form of a board, and a plurality of electric/electronic components such as semiconductors, capacitors, or resistors may be mounted thereon. The mounted electric/electronic components may be electrically connected to each other through an electric line circuit printed on the PCB. In the PCB, electric lines may be efficiently designed to reduce a size of an electronic equipment, and improve performance and productivity thereof.

The plurality of electric/electronic components mounted on the PCB may transmit or receive electrical signals. However, when an amount of electrical signals to be transmitted or received increase or high-speed processing of signals is required, a phenomenon in which a signal processing speed is decreased occurs, and this cause performance degradation of the PCB. In order to resolve the decrease in signal processing speed, methods such as a method of increasing the number of layers of the PCB to increase accommodating capacity for the components, are used.

The PCB includes high-speed digital ICs and high-speed signal traces, and
becomes gradually complicated due to connections of a power source, I/O port, and the like, and common-mode current may be generated in a PCB substrate due to a discontinuity of high-speed switching current or a signal return current path, or the like. The generated common-mode current may be a main cause of coupling to power lines or signal lines to cause electromagnetic radiation. Thus, in order to decrease the generated electromagnetic radiation, the PCB needs to be grounded to reduce introduction of noise caused by the electromagnetic radiation into the electrical signals transmitted or received by the electric/electronic components mounted on the PCB.

In structures for grounding PCB substrates according to the related art, a coupling unit which couples and simultaneously electrically connects a PCB substrate to other components presses a bushing unit, which electrically connects the PCB to the coupling unit, together with a case, but not press the bushing unit completely alone. Accordingly, the structures according to the related art have problems that the bushing unit and the PCB substrate are not completely in contact with each other and rather the coupling unit presses the case to cause damage to the case, and contact force between the bushing unit and a circuit board is decreased so that the circuit board is not grounded and thus, an electric circuit of the PCB substrate does not normally operate.

Accordingly, there is a need for technical development to solve the problems as above.

### DISCLOSURE OF THE INVENTION

### TECHNICAL PROBLEM

An object of the present invention for solving the above problems is to provide a BMS assembly in which pressing force of a coupling unit is entirely applied to a bushing part so that a casing mold is not damaged and also, contact force between the bushing part and a circuit board is improved.

### TECHNICAL SOLUTION

As one embodiment of the present invention, the present invention provides a battery management system (BMS) including: a circuit board in which a first coupling hole for grounding is defined; a first casing mold that accommodates the circuit board, and includes a bushing part disposed inside a second coupling hole recessed from the outside; and a coupling unit that passes through the first coupling hole and the second coupling hole, and allows the circuit board and the bushing part to be in contact with each other while pressing a top surface of the bushing part, wherein the bushing part includes: a vertical part provided in a direction parallel to the second coupling hole; and a horizontal part extending from an end of the vertical part in a direction perpendicular to a direction in which the vertical part is provided, wherein the coupling unit is electrically connected to a case, in which a plurality of batteries are accommodated, to ground the circuit board.

The bushing part may include an electrically conductive metal material.

The vertical part may be provided along a circumference of an inner lower end of the second coupling hole, and the horizontal part may be provided on an upper end of the vertical part.

The coupling unit may be in contact with a top surface of the horizontal part to press the horizontal part downwardly, and
the horizontal part may extend so that the top surface thereof is wider than an area on which the coupling unit is in contact with the top surface of the horizontal part.

At least a portion of a bottom surface of the horizontal part may be exposed to face the circuit board.

The vertical part may provide a stepped portion in the second coupling hole.

The coupling unit may include a bolt and a nut, the bolt may pass through the first coupling hole and the second coupling hole, and the nut may be coupled to the bolt and press the top surface of the bushing part.

A third coupling hole through which the coupling unit passes may be defined in a lower portion of the circuit board, and the BMS assembly may further include a second casing mold that accommodates the circuit board.

The BMS assembly may further include a leg unit, which supports a lower portion of the second casing mold, in which a fourth coupling hole through which the coupling unit passes is defined, and which is in contact with and electrically connected to the coupling unit.

The leg unit may include an electrically conductive metal material.

The leg unit may include: a seating part in which the second casing mold is seated; and a plurality of leg parts, each of which is bent downward from the seating part and has an end coupled to a battery module case or a battery pack case.

The BMS assembly may further include a connector which is disposed between the horizontal part and the circuit board and has one end in contact with a bottom surface of the horizontal part, and the other end in contact with the top surface of the circuit board, and which electrically connects the bushing part to the circuit board.

The connector may include an electrically conductive metal material.

The connector may include: a first unit which has one end in which an opening portion is defined, and in which an elastically deformable elastic unit is provided; and a second unit slidably movable with respect to the first unit through the opening portion, and having one end that is coupled to the elastic unit.

The elastic unit may be a spring.

As another embodiment of the present invention, the present invention provides a battery module including: a battery module case in which a plurality of batteries are accommodated; and a battery management system (BMS) assembly coupled to the battery module case, wherein the BMS assembly includes: a circuit board in which a first coupling hole for grounding is defined; a first casing mold that accommodates the circuit board, and includes a bushing part disposed inside a second coupling hole recessed from the outside; and a coupling unit that passes through the first coupling hole and the second coupling hole, and allows the circuit board and the bushing part to be in contact with each other while pressing a top surface of the bushing part, wherein the bushing part includes: a vertical part provided in a direction parallel to the second coupling hole; and a horizontal part extending from an end of the vertical part in a direction perpendicular to a direction in which the vertical part is provided, wherein the coupling part is electrically connected to the battery module case to ground the circuit board.

As still another embodiment of the present invention, the present invention provides a battery pack including: a battery pack case in which a battery module in which a plurality of secondary batteries are accommodated is provided in plurality to be accommodated; and a battery management system (BMS) coupled to the battery pack case, wherein the BMS assembly

includes: a circuit board in which a first coupling hole for grounding is defined; a first casing mold that accommodates the circuit board, and includes a bushing part disposed inside a second coupling hole recessed from the outside; and a coupling unit that passes through the first coupling hole and the second coupling hole, and allows the circuit board and the bushing part to be in contact with each other while pressing a top surface of the bushing part, wherein the bushing part includes: a vertical part provided in a direction parallel to the second coupling hole; and a horizontal part extending from an end of the vertical part in a direction perpendicular to a direction in which the vertical part is provided, wherein the coupling part is electrically connected to the battery module case to ground the circuit board.

### ADVANTAGEOUS EFFECTS

In the present invention, the shape of one edge of the circuit board may be provided to be asymmetric to the shape of the other edge so that in the assembly process of assembling the electronic components on the circuit board, whether the arrangement direction of the circuit board is correct may be intuitively determined based on the position of the asymmetric part edge shape. Accordingly, the electronic components may be prevented in advance from being assembled in the wrong direction due to the circuit board arrangement error in the assembly process.

In addition, the present invention may fix the circuit board at a time to the guide case, to which the circuit board is coupled, so as to easily assemble the electronic components and the circuit board, and simultaneously may ground the circuit board to improve the efficiency of the assembly process. Moreover, the asymmetric part of the circuit board may have the ground patterns having the large area so that the contact area with the guide unit is increased to improve the grounding function.

### BRIEF DESCRIPTION OF THE DRAWINGS

FIG. 1 is a perspective view illustrating an outer appearance of a BMS assembly according to the present invention.
FIG. 2 is a cross-sectional view illustrating first, second, third, and fourth coupling holes in a state in which a coupling unit is removed in the BMS assembly taken along in a direction AA' in FIG. 1.
FIG. 3 is a cross-sectional view illustrating the BMS assembly taken along in the direction AA' in FIG. 1.
FIG. 4 is a perspective view illustrating a bushing part according to the present invention.
FIG. 5 is a cross-sectional view specifically illustrating a state in which a connector is added between a circuit board and a bushing part in a portion B in FIG. 3.
FIG. 6 illustrates (a) a perspective view and (b) a cross-sectional view of a connector according to the present invention.

### MODE FOR CARRYING OUT THE INVENTION

Hereinafter, preferred embodiments of the present invention will be described in detail with reference to the accompanying drawings to enable those skilled in the art to which the present invention pertains to easily carry out the present invention. The present invention may, however, be embodied in different forms and should not be construed as limited by the embodiments set forth herein.

The parts unrelated to the description, or the detailed descriptions of related well-known art that may unnecessarily obscure subject matters of the present invention, will be ruled out in order to clearly describe the present invention. Like reference numerals refer to like elements throughout the whole specification.

Moreover, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

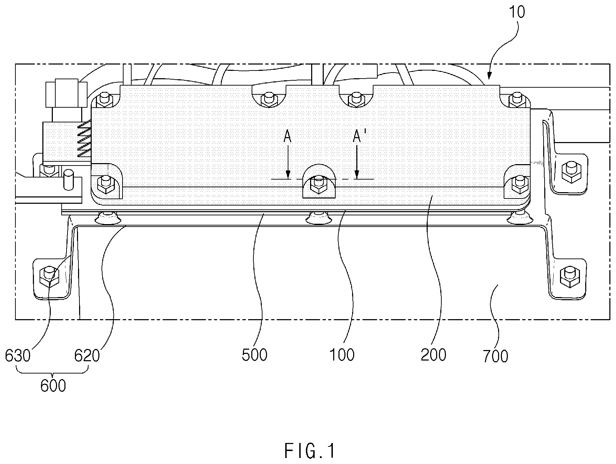

Referring to FIGS. 1 to 3, a BMS assembly 10 according to the present invention may include a circuit board 100, a first casing mold 200, a coupling unit 300, a second casing mold 500, and a leg unit 600. The BMS assembly 10 may include a structure for grounding the circuit board 100.

A battery management system (BMS) may be a system that is coupled to a battery back or a battery module and senses various factors such as current, voltages, or temperatures, of batteries accommodated inside the battery back or the battery module, to detect charging amounts of the batteries, time to replace the batteries, problems occurring in the batteries, and the like so that the batteries are manage and maintain in an optimum state.

The circuit board 100 included in the BMS assembly 10 may include various types of circuit boards, for example, a printed circuit board (PCB), a flexible printed circuit board (FPCB), a rigid-flexible printed circuit board (RF-PCB), and a high density interconnection (HDI), and preferably, the circuit board 100 may be a PCB circuit board. However, the circuit board 100 is not limited thereto.

A first coupling hole 110 may be defined in one side of the circuit board 300.

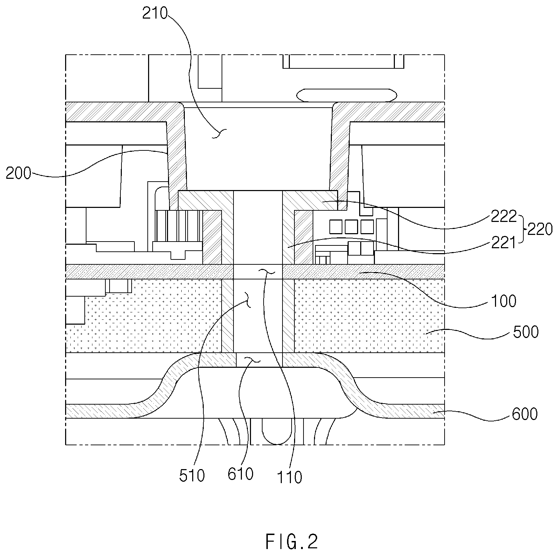

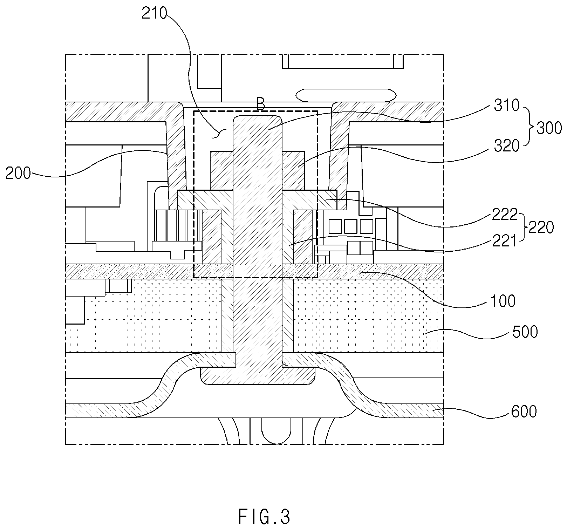

Referring to FIGS. 2 and 3, the coupling unit 300 may be inserted into the first coupling hole 110 so as to couple and fix the circuit board 300 to the first casing mold 200, the second casing mold 500, the leg unit 600, and the like.

The first coupling hole 110 may be electrically connected to a ground plane, a ground pad, a ground pattern, or the like, provided on the circuit board 100 so as to ground the circuit board 300. When the circuit board 100 is stably grounded, reference potential of each of a plurality of electronic components mounted on the circuit board 100 and electric circuit patterns may be set to induce current to flow as intended by a designer of the circuit board, and introduction of noise into the electrical signals transmitted or received by the electronic components may be reduced.

The first casing mold 200 may have an inner space defined therein, and be disposed above the circuit board 100 to accommodate the circuit board 100 and the electronic components mounted on one surface of the circuit board 100.

A second coupling hole 210 may be defined in one side of the first casing mold 200. The second coupling hole 210 may be a hole recessed inward from the outside of the first casing mold 200.

A bushing part 220 may be provided on an inner lower end of the second coupling hole 210.

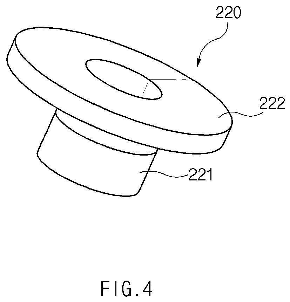

Referring to FIGS. 3 and 4, the bushing part 220 may be a component provided so that when the coupling unit 300 presses the component in order to couple the first casing mold 200 to the circuit board 100, the component is in contact with the coupling unit 200 and pressing force of the coupling unit 300 is transmitted to the component so that the component is in contact with the circuit board 100 while supporting the circuit board 100. The bushing part 220 that is in contact with circuit board 100 may be electrically connected to the circuit board 100.

The bushing part 220 may include a vertical part 221 and a horizontal part 222.

The bushing part may include an electrically conductive material so as to electrically connect the coupling unit 300 and the circuit board 100 to each other. In addition, the bushing part may include a metal material having greater mechanical strength than plastic, polymer resin, or the like, which is a material of the second coupling hole 210, so as to withstand the pressing force of the coupling unit 300.

The vertical part 221 may be provided along a circumference of an inner surface of an inner lower end of the second coupling hole 210, and may be provided in a direction parallel to a virtual vertical central axis passing through the second coupling hole 210.

The vertical part 221 may have a lower end, which is in contact with the circuit board 100, and an upper end on which the horizontal part is provided.

An inner side surface of the vertical part 221 may be spaced a predetermined distance from an outer side surface of a bolt 310 of the coupling unit 300, which is inserted into the second coupling hole 210, and thus may not be in contact with the bolt 310. Thus, the inner side surface of the vertical part 221 may have a diameter that is greater than a diameter of the bolt 310. Accordingly, the inner side surface of the vertical part 221 and the outer side surface of the bolt 310 may not be in contact with each other so that current is induced to flow through the circuit board 100, the vertical part 221, the horizontal part 222, a nut 320, the bolt 310, the leg unit 600, and a battery module case 700 in this order. Accordingly, a single circuit for grounding may be provided, and the introduction of noise may be reduced. However, when the inner side surface of the vertical part 221 and the outer side surface of the bolt 310 are in contact with each other, current may flow through the circuit board 100, the vertical part 221, the bolt 310, the leg unit 600, and the battery module case 700 in this order. Accordingly, another circuit for grounding may be provided, and the noise problem may occur.

The horizontal part 222 may be provided to extend from an end portion of the upper end of the vertical part 221 in a direction perpendicular to the virtual vertical central axis passing through the second coupling hole 210 in a direction in which the vertical part 221 is provided. The horizontal part 222 may provide a stepped portion in the second coupling hole 210, and a hole size may be expanded at an upper end of the second coupling hole 210 rather than a lower end of the second coupling hole 210.

In addition, as the material of the horizontal part 222 is a metal material having greater mechanical strength than the material of the second coupling hole 210, the first casing mold 200 may be prevented from being damaged even though the horizontal part 222 is in contact with the coupling unit 300 and the pressing force of the coupling unit 300 is entirely applied to the horizontal part 222.

A figure provided along a circumference of a distal end of the horizontal part 222 may be a similar figure to a horizontal cross-section figure of the vertical part 221.

The horizontal part 222 may be bent outward from the upper end of the vertical part 221 so as to have a radial shape.

A top surface of the horizontal part 222 may be a surface, which is in contact with a bottom surface of the nut 320 of the coupling unit 300 so that a pressure, which the nut 320 of the coupling unit 300 applies downwardly while being tightened, is applied directly to the surface. The top surface of the horizontal part 222 may have an area that is provided to be greater than a contact area on which the top surface of the horizontal part 222 is in contact with the coupling unit 300. The bottom surface of the nut 320 may be in contact only with the top surface of the horizontal part 222.

The horizontal part 222 may have a length that is the same as or similar to a length of the vertical part 221 on a longitudinal cross-section of the bushing part 220. The horizontal part 222 may have a thickness that is greater than a thickness of the vertical part 221 so as to well support the pressing pressure of the nut 320.

At least a portion of the bottom surface of the horizontal part 222 may be exposed so as to directly face a top surface of the circuit board 100. A connector 400 may be disposed between the exposed bottom surface of the horizontal part 222 and the top surface of the circuit board 100 so as to electrically connect the horizontal part 222 to the circuit board 100.

An outer side surface of the vertical part 221 may be surrounded by the second coupling hole 210.

As the first casing mold 200 includes a material such as a polymer resin or polymer plastic material, and the bushing part 220 provided in the second coupling hole 210 includes a metal material, the first casing mold 200 may be made through insert injection molding so that a plurality of types of different materials such as metal and plastic are integrated.

The coupling unit 300 may be a unit for coupling and fixing the circuit board 100, the first casing mold 200, and the second casing mold 500 to each other.

The coupling unit 300 may include the bolt 310 and the nut 320, and the nut 320 may be coupled to the bolt 310.

The bolt 310 may include a head part and a body coupled to the head part. The body may have a cylindrical shape so that a screw protrudes spirally along a circumference of an outer surface of the body. The nut 320 may have a hole through which top and bottom surfaces thereof communicate with each other, and an inner side surface in which a thread groove through which the nut 320 is coupled to the bolt 310 is defined to correspond to the screw provided on the outer surface of the bolt 310. When the nut 320 is coupled to the body of the bolt 310 and rotated in one direction, the nut 320 may move in a longitudinal direction of the bolt 310 toward a direction in which the head part is provide. When the nut 320 is rotated in an opposite direction, the nut 320 may move in the longitudinal direction of the bolt 310 toward a direction opposite to the direction in which the head part is provide.

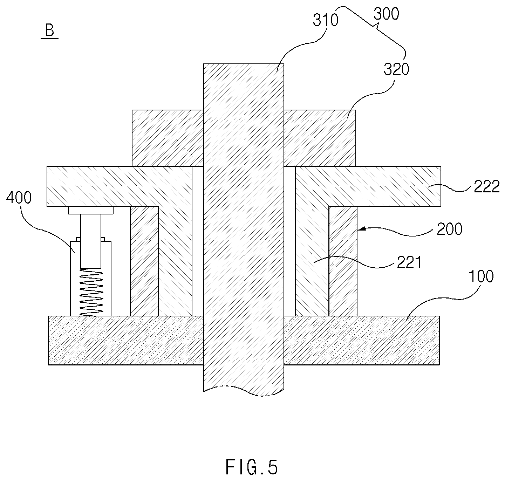

Referring to FIG. 5, the BMS assembly 10 may further include the connector 400. The connector 400 may be a component for electrically connecting the bottom surface of the horizontal part 222 and the top surface of the circuit board 100 to each other.

As the lower end of the vertical part 221 is in contact with the circuit board 100, the bushing part 220 and the circuit board 100 may be electrically connected to each other. The connector 400 may be disposed between the bottom surface of the horizontal part 222, which is exposed to face the bottom surface of the circuit board 100, and the top surface of the circuit board 100 so that the bushing part 220 and the circuit board 100 are electrically connected to each other. Accordingly, the connector 400 may be disposed so that one end thereof is in contact with the bottom surface of the horizontal part 222, and the other end is in contact with the top surface of the circuit board 100.

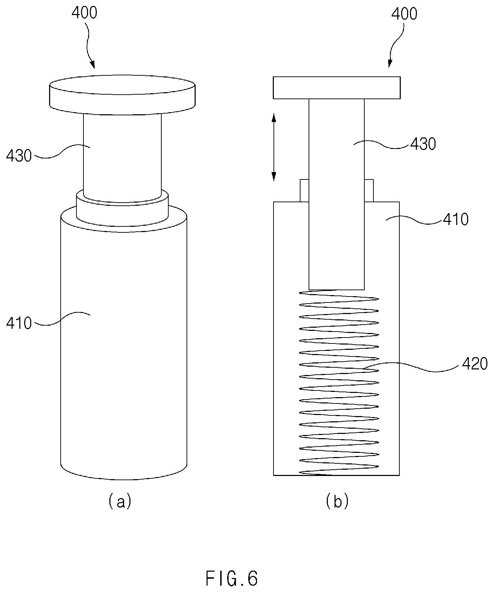

Referring to FIG. 6, the connector 400 may include a first unit 410, an elastic unit 420, and a second unit 430.

The connector 400 may include an electrically conductive metal material so as to electrically connect the bushing part 220 and the circuit board 100 to each other to ground the circuit board 100.

The first unit 410 may have, for example, a shape such as a cylindrical pillar, a square pillar, or the like, but is not limited thereto.

The first unit 410 may have one end in which an opening portion is defined, and an inner space which communicates with the opening portion may be defined therein.

The elastic unit 420 disposed in a longitudinal direction of the first unit 410 may be coupled to the inner space of the first unit 410.

The elastic unit 420 may be a component, which is capable of being elastically deformed so that when external force is applied to the component, the component is deformed, and when the force is removed, the component is restored to its initial shape due to restoring force. The elastic unit may be, for example, a spring, but is not limited thereto.

The second unit 430 may be inserted into the opening portion of the first unit 410 so as to be coupled to the first unit 410. The second unit 430 may have a cross-section having a shape and a size that correspond to a shape and a size of the opening portion of the first unit 410, respectively. The second unit 430 may be coupled to the first unit 410 and adjust a length of the connector 400 in a longitudinal direction while slidably moving with respect to the first unit 410.

As one end of the second unit 430 is coupled to the elastic unit 420 of the first unit 410, when the second unit 430 moves in a direction that is close to the first unit 410, the second unit 430 may push the elastic unit 420 so that the elastic unit 420 is deformed to be contracted, and the elastic unit 420 applies elastic force in a direction opposite to a traveling direction of the second unit 430.

The other end of the second unit 430 may be in contact with the bottom surface of the horizontal part 222 or the top surface of the circuit board 100.

A basic length of the connector 400 in the longitudinal direction, which is provided when the second unit 430 does not push the elastic unit 420 to compress and deform the elastic unit 420, may be provided to be greater than a vertical distance between the bottom surface of the horizontal part 222 and the top surface of the circuit board 100. As due to the elastic force caused by the compressive deformation of the elastic unit 420, the first unit 410 and the second unit 430 are in contact with the bottom surface of the horizontal part 222 and the top surface of the circuit board 100, respectively, a position of the connector 400 may be fixed in a space between the bottom surface of the horizontal part 222 and the top surface of the circuit board 100.

When the nut 320 is rotated in one direction to more strongly press the bushing part 220, a spaced distance between the horizontal part 222 and the circuit board 100 may be decreased, and also the connector 400 disposed between the horizontal part 222 and the circuit board 100 may be adjusted to correspond to the changed spaced distance between the horizontal part 222 and the circuit board 100.

The second casing mold 500 may be disposed below the circuit board 100, and the second casing mold 500 together with the first casing mold 200 may accommodate the circuit board 100 in the inner space.

The first casing mold 200 and the second casing mold 500 may be coupled to each other through the coupling unit 300. As the first casing mold 200 and the second casing mold 500 are coupled to each other, the inner space may be defined, and the circuit board 100 may be disposed in the defined inner space so that the first casing mold 200 and the second casing mold 500 protect the circuit board 100 disposed therein.

Referring to FIGS. 2 and 3, a third coupling hole 510 may be defined in one side of the second casing mold 500.

The first coupling hole 110, the second coupling hole 210, and the third coupling hole 510 may be disposed to match respective virtual vertical central axes passing through of the coupling holes 110, 210 and 510, so that the bolt 310 of the coupling unit 300 is inserted into the coupling holes 110, 210 and 510.

The second casing mold 500 may be made of a material such as synthetic resin or plastic through insert injection molding.

The leg unit 600, which supports the second casing mold 500 and is coupled to the second casing mold 500 through the coupling unit 300, may be disposed below the second casing mold 500.

Referring to FIGS. 2 and 3, a fourth coupling hole 610 may be defined in one surface of the leg unit 600 so that the coupling unit 300 is inserted into the fourth coupling hole 610 to couple the leg unit 600 to the second casing mold 500.

The fourth coupling hole 610 may be disposed to have a virtual vertical central axis that matches the respective virtual vertical central axes of the first coupling hole 110, the second coupling hole 210, and the third coupling hole 510 so that the bolt 310 of the coupling unit 300 is inserted into the fourth coupling hole 610.

The bolt 310 may pass through the fourth coupling hole 610, and the bolt 310 coupled to the nut 320 may press the leg unit 600 through the head part of the bolt 310 on a bottom surface of the leg unit 600.

The leg unit 600 may include a seating part 620 and a leg part 630.

The seating part 620 may be disposed on a top surface of the leg unit 600, and the second casing mold 500 may be seated on the seating part 620. When the second casing mold 500 is seated on the seating part 620, the fourth coupling hole 610 and the third coupling hole 510 may be disposed to match the respective virtual vertical central axes passing through the coupling holes 510 and 610 so that the coupling unit 300 couples the leg unit 600 to the second casing mold 500.

The leg part 630 may be bent from an end of the seating part 620 in a downward direction that is a direction that is away from the second casing mold 500 seated on the seating part 620.

The leg part 630 may be coupled so that a distal end thereof is in contact with the battery pack or battery module case 700. When the leg part 630 is coupled to the battery pack or battery module case 700, the top surface of the circuit board 100 may be electrically connected to the bushing part 200, the coupling unit 300, and the leg unit 600 in sequence, and finally grounded to the battery module case 700.

The leg unit 600 may include an electrically conductive metal material so that the leg unit 600 is coupled and electrically connected to the bolt 310 of the coupling unit 300.

### Battery module

The battery module may include a battery module case 700 and a BMS assembly 10. A plurality of batteries may be accommodated in an inner space of the battery module case 700. Each of the batteries may be provided in various types such as a pouch type, a cylindrical type, or a prismatic type. The battery module case 700 may have a shape that is not limited, and include an electrically conductive metal material. A leg unit 600 of the BMS assembly 10 may be coupled to one surface of the battery module case 700, and a circuit board 100 may be electrically connected to a vertical part 221, a horizontal part 222, a nut 320, a bolt 310, the leg unit 600, and the battery module case 700 in sequence so as to be stably grounded. The specific content of the BMS assembly 10 may be replaced with the content described above.

### Battery pack

The battery pack may include a battery pack case (not shown) and a BMS assembly 10. A plurality of battery modules may be accommodated in an inner space of the battery pack, and a plurality of batteries may be accommodated in each of the battery modules. Each of the batteries may be provided in various types such as a pouch type, a cylindrical type, or a prismatic type. The battery pack case may have a shape that is not limited, and include an electrically conductive metal material. A leg unit 600 of the BMS assembly 10 may be coupled to one surface of the battery pack case, and a circuit board 100 may be electrically connected to a vertical part 221, a horizontal part 222, a nut 320, a bolt 310, the leg unit 600, and the battery pack case in sequence so as to be stably grounded. The specific content of the BMS assembly 10 may be replaced with the content described above.

Although the present invention has been described with reference to the limited embodiments and drawings, the present invention is not limited thereto and may be variously implemented by those of ordinary skill in the art to which the present invention pertains, within the technical idea of the present invention and an equivalent of the appended claims.

### [Description of the Symbols]

10: BMS assembly
100: Circuit board
110: First coupling hole
200: First casing mold
210: Second coupling hole
220: Bushing part
221: Vertical part
222: Horizontal part
300: Coupling unit
310: Bolt
320: Nut
400: Connector
410: First unit
420: Spring
430: Second unit
500: Second casing mold
510: Third coupling hole
600: Leg unit
610: Fourth coupling hole
620: Seating part
630: Leg part
700: Battery module case

## Claims

1. A battery management system (BMS) assembly comprising:
a circuit board in which a first coupling hole for grounding is defined;
a first casing mold configured to accommodate the circuit board, and comprising a bushing part that is disposed inside second coupling hole recessed from the outside; and
a coupling unit passing through the first coupling hole and the second coupling hole, and configured to allow the circuit board and the bushing part to be in contact with each other while pressing a top surface of the bushing part,
wherein the bushing part comprises:
a vertical part provided in a direction parallel to the second coupling hole; and
a horizontal part extending from an end of the vertical part in a direction perpendicular to a direction in which the vertical part is provided,
wherein the coupling unit is electrically connected to a case, in which a plurality of batteries are accommodated, to ground the circuit board.

2. The BMS assembly of claim 1, wherein the bushing part comprises an electrically conductive metal material.

3. The BMS assembly of claim 1, wherein the vertical part is provided along a circumference of an inner lower end of the second coupling hole, and
the horizontal part is provided on an upper end of the vertical part.

4. The BMS assembly of claim 1, wherein the coupling unit is in contact with a top surface of the horizontal part to press the horizontal part downwardly, and
the horizontal part extends so that the top surface thereof is wider than an area on which the coupling unit is in contact with the top surface of the horizontal part.

5. The BMS assembly of claim 4, wherein at least a portion of a bottom surface of the horizontal part is exposed to face the circuit board.

6. The BMS assembly of claim 5, wherein the vertical part provides a stepped portion in the second coupling hole

7. The BMS assembly of claim 1, wherein the coupling unit comprises a bolt and a nut,
wherein the bolt passes through the first coupling hole and the second coupling hole, and
the nut is coupled to the bolt and presses the top surface of the bushing part.

8. The BMS assembly of claim 1, wherein a third coupling hole, through which the coupling unit passes is defined, in a lower portion of the circuit board, and
the BMS assembly further comprises a second casing mold configured to accommodate the circuit board.

9. The BMS assembly of claim 8, further comprising a leg unit which is configured to support a lower portion of the second casing mold, in which a fourth coupling hole through which the coupling unit passes is defined, and which is in contact with and electrically connected to the coupling unit.

10. The BMS assembly of claim 9, wherein the leg unit comprises an electrically conductive metal material.

11. The BMS assembly of claim 9, wherein the leg unit comprises:
a seating part in which the second casing mold is seated; and
a plurality of leg parts, each of which is bent downward from the seating part and has an end coupled to a battery module case or a battery pack case.

12. The BMS assembly of claim 1, further comprising a connector which is disposed between the horizontal part and the circuit board and has one end in contact with a bottom surface of the horizontal part, and the other end in contact with the top surface of the circuit board, and which is configured to electrically connect the bushing part to the circuit board.

13. The BMS assembly of claim 12, wherein the connector comprises an electrically conductive metal material.

14. The BMS assembly of claim 12, wherein the connector comprises:
a first unit which has one end in which an opening portion is defined, and in which an elastically deformable elastic unit is provided; and
a second unit slidably movable with respect to the first unit through the opening portion, and having one end that is coupled to the elastic unit.

15. The BMS assembly of claim 14, wherein the elastic unit is a spring.

16. A battery module comprising:
a battery module case in which a plurality of batteries are accommodated; and
a battery management system (BMS) assembly coupled to the battery module case,
wherein the BMS assembly comprises:
a circuit board in which a first coupling hole for grounding is defined;
a first casing mold configured to accommodate the circuit board, and comprising a bushing part disposed inside a second coupling hole recessed from the outside; and
a coupling unit passing through the first coupling hole and the second coupling hole, and configured to allow the circuit board and the bushing part to be in contact with each other while pressing a top surface of the bushing part,
wherein the bushing part comprises:
a vertical part provided in a direction parallel to the second coupling hole; and
a horizontal part extending from an end of the vertical part in a direction perpendicular to a direction in which the vertical part is provided,
wherein the coupling part is electrically connected to the battery module case to ground the circuit board.

17. A battery pack comprising:
a battery pack case in which a battery module in which a plurality of secondary batteries are accommodated is provided in plurality to be accommodated; and
a battery management system (BMS) coupled to the battery pack case,
wherein the BMS assembly comprises:
a circuit board in which a first coupling hole for grounding is defined;
a first casing mold configured to accommodate the circuit board, and comprising a bushing part disposed inside a second coupling hole recessed from the outside; and
a coupling unit passing through the first coupling hole and the second coupling hole, and configured to allow the circuit board and the bushing part to be in contact with each other while pressing a top surface of the bushing part,
wherein the bushing part comprises:
a vertical part provided in a direction parallel to the second coupling hole; and
a horizontal part extending from an end of the vertical part in a direction perpendicular to a direction in which the vertical part is provided,
wherein the coupling part is electrically connected to the battery module case to ground the circuit board.
